(19) Europäisches Patentamt
European Patent Office
Office européen des brevets

(11) **EP 1 835 532 A1**

(12) **EUROPEAN PATENT APPLICATION**

(43) Date of publication:
**19.09.2007 Bulletin 2007/38**

(51) Int Cl.:
***H01L 21/67*** *(2006.01)*

(21) Application number: **07103586.9**

(22) Date of filing: **06.03.2007**

| | |
|---|---|
| (84) Designated Contracting States:<br>**AT BE BG CH CY CZ DE DK EE ES FI FR GB GR HU IE IS IT LI LT LU LV MC MT NL PL PT RO SE SI SK TR**<br>Designated Extension States:<br>**AL BA HR MK YU**<br><br>(30) Priority: **13.03.2006 JP 2006067710** | (71) Applicant: **Ricoh Company, Ltd.**<br>**Tokyo 143-8555 (JP)**<br><br>(72) Inventor: **Murayama, Noboru**<br>**Tokyo 143-8555 (JP)**<br><br>(74) Representative: **Schwabe - Sandmair - Marx**<br>**Stuntzstrasse 16**<br>**81677 München (DE)** |

(54) **A conveyance apparatus having an improved compact conveying mechanism**

(57) A conveyance apparatus includes an extendable and retractable mechanism, which includes a plurality of linked member pairs rotatably coupled across each other horizontally in a predetermined direction in pantograph form, a multiple-layer slider, which includes a carrier slider to hold a work product and fixed at one end of the extendable mechanism and at least one movable slider to move in a predetermined direction keeping a predetermined relative position to the carrier slider, and a drive mechanism configured to cause the linked member pairs to expand by changing a relative angle of the crossing linked member pairs.

# FIG. 3

## Description

This patent specification is based on Japanese patent application, No. 2006-067710 filed on March 13, 2006 in the Japan Patent Office, the entire contents of which are incorporated by reference herein.

## BACKGROUND OF THE INVENTION

## FIELD OF THE INVENTION

The present invention relates to a conveyance apparatus, and more particularly to a conveyance apparatus having an improved compact conveyance mechanism.

## DISCUSSION OF THE BACKGROUND

A variety of information technologies have been developed rapidly in conjunction with recent trend of digitalization of information data. It has become realized to handle large volumes of the information data by such information technologies. Handling the large information data, it is especially important to develop higher density storage mediums than the existing storage mediums, for example, CD (compact disk) and DVD (digital versatile disk), etc. to store the large information data.

An optical disk as a high density storage medium is requested to have a finer pattern with a smaller pitch so as to store the large information data. The information data may be written and played by exposing an ultra-violet light having a wavelength of 400nm onto the optical disk.

In manufacturing process of the optical disk, a master disk (stamper) is initially prepared. The optical disk is then manufactured using the master. An electron-beam-lithography apparatus is widely used in the manufacturing process of the master disk under a vacuum condition of $10^{-4}$PA. The electron-beam-lithography apparatus irradiates electron beam onto a surface of a work product such as wafer, etc. so as to form the fine pattern.

The electron-beam-lithography apparatus generally employs so called three-chambers-and-one-transfer configuration which includes a vacuum process room, a load-lock room and a transfer room. The transfer room is connected to the vacuum process room and the load-lock room. In the vacuum process room, the fine pattern is drawn on the work product under a predetermined vacuum condition. The work product is conveyed from outside where it is under a circumstance of atmospheric pressure. The work product is held in the load-lock room. The work product is then conveyed to the vacuum process room by a conveying arm provided in the transfer room.

If the work product having a larger size is employed to improve a manufacturing efficiency, a large transfer room is necessary to ensure enough stroke of the conveying arm. As a result, there is a penalty in large size of the electron-beam-lithography apparatus.

Another background electron-beam-lithography apparatus employs so called two-chambers-and-one-transfer configuration where a conveyance mechanism is provided in a load-lock room and a transfer room is not arranged. However, there is a penalty in large size of the electron-beam-lithography apparatus similarly.

Another background electron-beam-lithography apparatus employs a telescope-structure conveyance mechanism which includes a plurality of sliders to ensure the conveyance stroke of the conveyance mechanism. However, it is necessary to employ pulleys and belts to connect the sliders. Therefore, a complicated drive mechanism is necessary to control movements of the sliders to have a predetermined mutual relation ship.

## SUMMARY OF THE INVENTION

This patent specification describes a novel conveyance apparatus includes an extendable mechanism, which includes a plurality of linked member pairs rotatably coupled across each other horizontally in a predetermined direction in pantograph form, a multiple-layer slider, which includes a carrier slider to hold a work product and fixed at one end of the extendable mechanism and at least one movable slider to move in a predetermined direction keeping a predetermined relative position to the carrier slider, and a drive mechanism configured to cause the linked member pairs to expand by changing a relative angle of the crossing linked member pairs.

Further, this patent specification describes a novel vacuum process apparatus which employs the conveyance apparatus described above and includes a vacuum process room to draw a fine pattern onto the work product therein and a load-lock room connected to the vacuum process room through a gate valve. The conveyance apparatus is provided in the load-lock room and carries the work product conveyed from outside of the load-lock room and to the vacuum process room.

## BRIEF DESCRIPTION OF THE DRAWINGS

A more complete appreciation of the disclosure and many of the attendant advantages thereof will be readily obtained as the same becomes better understood by reference to the following detailed description when considered in connection with the accompanying drawings, wherein:

   FIG. 1 illustrates a vacuum process apparatus according to a first example embodiment of the present disclosure;
   FIG. 2 illustrates a side view of a conveyance mechanism;
   FIG. 3 illustrates a plain view of the conveyance mechanism;
   FIG. 4A illustrates a plane view of a lazy-tongs arm when the lazy-tongs arm is expanded;

FIG. 4B illustrates a cross-sectional view of the lazy-tongs arm of FIG. 4A;

FIG. 5 illustrates the second vacuum chamber when the gate valve is at a closed position;

FIGs. 6A and 6B are illustrations to explain a stroke of the lazy-tongs arm;

FIGs. 7A and 7B are illustrations to explain operation of the vacuum process apparatus;

FIG. 8 illustrates a cross-sectional view of another conveyance mechanism;

FIG. 9 illustrates an inner view of the second vacuum chamber observing from a plus side of X-axis;

FIG. 10 is an illustration to explain operation of the loader;

FIG. 11 illustrates another example of arm-drive unit;

FIGs. 12A and 12B illustrates a pressuring unit; and

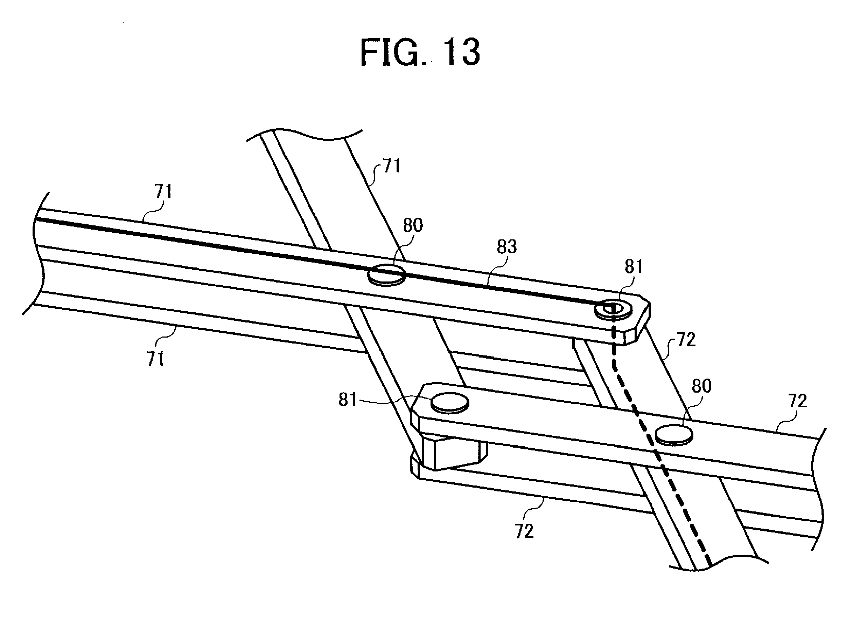

FIG. 13 illustrates a cable provided in the lazy-tongs arm.

## DETAILED DESCRIPTION OF PREFERRED EMBODIMENTS

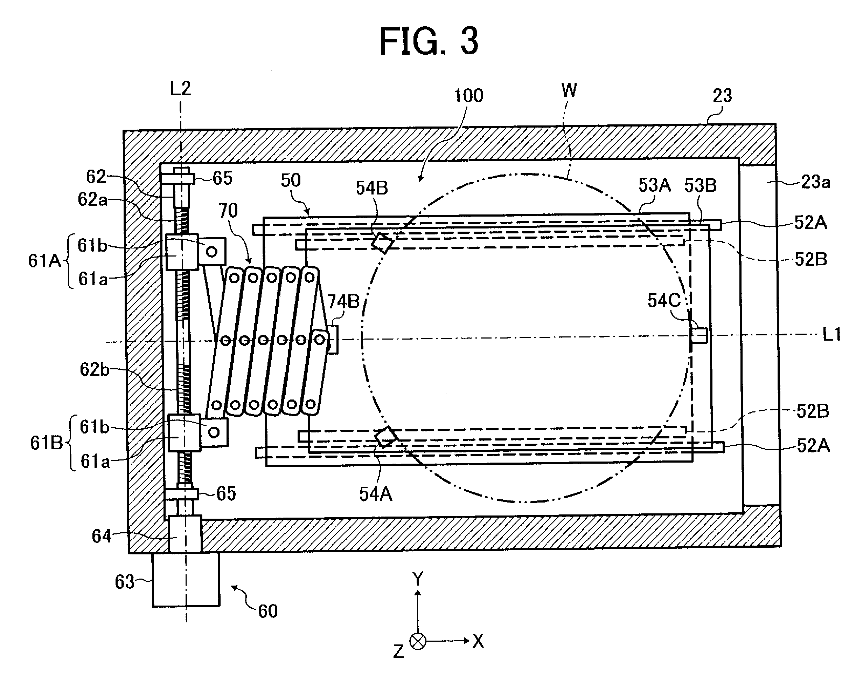

In describing preferred embodiments illustrated in the drawings, specific terminology is employed for the sake of clarity. However, the disclosure of this patent specification is not intended to be limited to the specific terminology so selected and it is to be understood that each specific element includes all technical equivalents that operate in a similar manner. Referring now to the drawings, wherein like reference numerals designate identical or corresponding parts throughout the several views, particularly to FIG. 3, a conveyance apparatus according to an embodiment of the present invention is described.

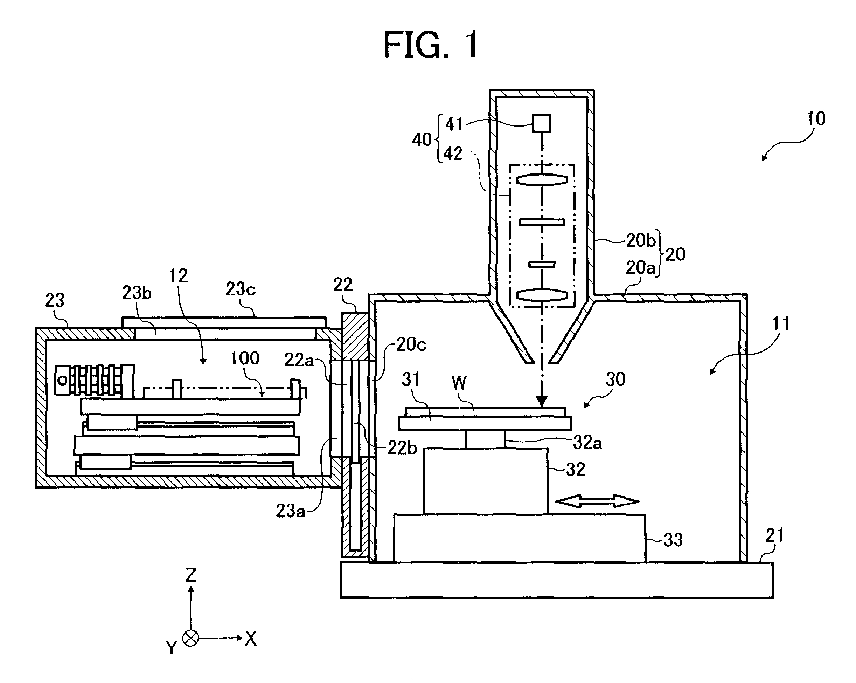

FIG. 1 illustrates a vacuum process apparatus 10 according to a first example embodiment of the present disclosure. The vacuum process apparatus 10 draws fine pattern on a surface of a work product W such as wafer, etc. by exposing an electron beam under a vacuum condition of, for example, $10^{-4}$PA. A resist film is coated on the surface of the work product W before an exposure process.

As shown in FIG. 1, the vacuum process apparatus 10 includes a rotating table unit 30, an exposure system 40, a conveyance mechanism 100, a first vacuum chamber 20, a gate valve 22, a second vacuum chamber 23 and a controller (not shown). The work product is placed on the rotating table unit 30. The exposure system 40 exposes the electron beam onto the work product W.

The first vacuum chamber 20 includes the rotating table unit 30 and the exposure system 40. The second vacuum chamber 23 is connected to the first vacuum chamber 20 through the gate valve 22. The controller controls a total system of the vacuum process apparatus 10.

The rotating table unit 30 is provided on a surface plate 21 arranged on a horizontal surface of the floor. The rotating table unit 30 includes a rotating table 31, a spindle motor 32 and a slide unit 33. On the rotating table 31, the work product W is provided. The spindle motor 32 holds the rotating table 31 horizontally by a shaft 32a. The shaft 32a of the spindle motor 32 is rotated with a predetermined rotating speed. The slide unit 33 holds the spindle motor 32 and drives to move the spindle motor 32 with a predetermined stroke in an X direction in FIG. 1.

The exposure system 40 is arranged above the rotating table unit 30. The exposure system 40 includes an electron gun 41 and a modulation unit 42. The electron gun 41 emits the electron beam vertically in a downward direction. The modulation unit 42 collimates the electron beam to the work product W provided on the rotating table 31.

For one example, the modulation unit 42 includes a condenser-lens, an aperture, a plurality of focus lenses. The modulation unit 42 controls to modulate the electron beam emitted from the electron gun 41 and exposes the electron beam by focusing the electron beam onto the surface of the work product W.

The first vacuum chamber 20 is provided touching tightly on the upper surface of the surface plate 21 with an under-part of first vacuum chamber 20. The first vacuum chamber 20 includes first and second chamber portions 20a and 20b. The first chamber portion 20a has a shape of a rectangular parallelepiped. The second chamber portions 20b has a cylindrical shape and is provided above the first chamber portion 20a.

The rotating table unit 30 is provided in the first chamber portion 20a and the exposure system 40 is provided in the second chamber portion 20b. At a surface of the first chamber portion 20a in a minus side of the X-axis in FIG. 1, an opening 20c is formed. The opening 20c has a rectangular shape and a long side of the rectangular opening is provided in the Y-axis direction. The first vacuum chamber 20 and the surface plate 21 form a room and is defined as a first vacuum room 11.

The second vacuum chamber 23 is connected to the first vacuum chamber 20 at the minus side of the X-axis in FIG. 1. An opening 23a having a similar shape to the opening 20c is formed at a surface of the second vacuum chamber 23 in the minus side of the X-axis in FIG. 1.

In an upper surface of the second vacuum chamber 23, an opening 23b is provided. A size of the opening 23b is much larger than the work product W. Further, a shutter 23c is provided on the upper surface of the second vacuum chamber 23. The shutter 23c opens and closes the opening 23b to outside of the second vacuum chamber 23 by sliding on the surface of the second vacuum chamber 23 in a direction of X-axis. The second vacuum chamber 23 forms a room and is defined as a load-lock room 12.

The gate valve 22 includes a frame member and a gate 22b. The frame member includes an opening 22a which passes through completely to the other side of the frame member in the X-axis direction. The gate 22b slides on the surface of the second vacuum chamber 23 in a direction of Z-axis to open and close the opening 22c.

The gate valve 22 touches tightly with the opening 20c of the first vacuum chamber 20 and the opening 23a of the second vacuum chamber 23 at both ends of the gate valve 22 in the X-axis direction. As a result, the first vacuum room 11 and the load-lock room 12 are sealed so as to be in a vacuum condition respectively when the gate valve 22 closes the opening 22a by sliding the gate 22b up to a plus side of Z-axis in FIG. 1.

The first vacuum room 11 and the load-lock room 12 communicates with each other when the gate valve 22 opens the opening 22a by sliding the gate 22b down to a minus side of Z-axis in FIG. 1.

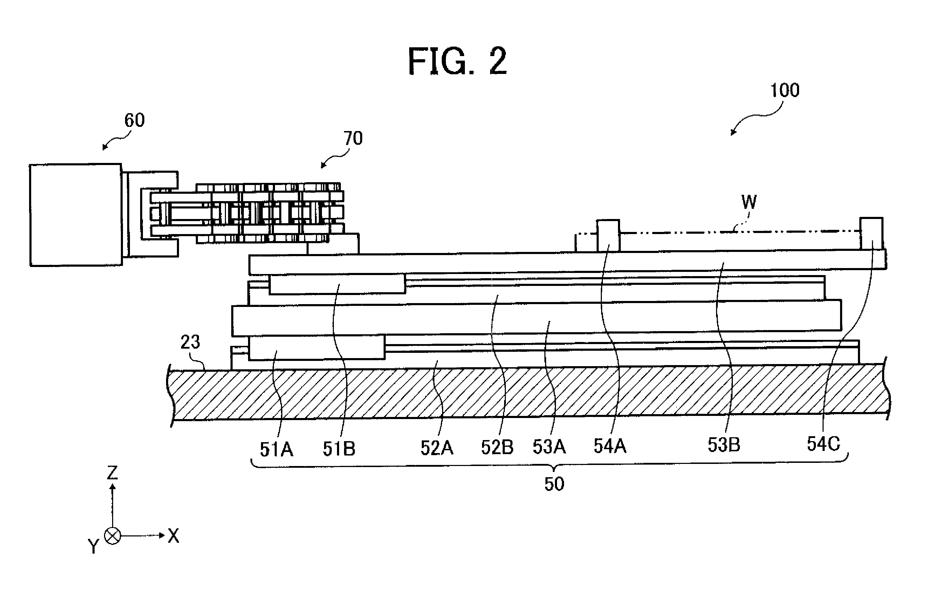

FIG. 2 illustrates a side view of the conveyance mechanism 100. The conveyance mechanism 100 includes a multiple-layer slider 50, a so-called lazy-tongs arm 70 and an arm-drive unit 60 as shown in FIG. 2. The multiple-layer slider 50 is provided on an upper surface of a base wall of the second vacuum chamber 23. The lazy-tongs arm 70 drives the multiple-layer slider 50 in a X-axis direction by expanding and retracting the lazy-tongs arm 70.

FIG. 3 illustrates a plain view of the conveyance mechanism 100. Referring to FIGs. 2 and 3, the multiple-layer slider 50 includes a pair of first linear guide 52A, a first slide table 53A, a pair of first moving members 51A, a pair of second linear guides 52B, a second slide table 53B and a pair of second moving members 51B.

The pair of first linear guides 52A are provided near edges at a minus side and another side of the Y-axis on the upper surface of the base wall of the second vacuum chamber 23 respectively. The pair of first linear guides 52A are fixed placing a long side of the first linear guides 52A in the X-axis direction. The first moving members 51A are provided slidably to engage with the first linear guides 52A in the X-axis direction.

The first slide table 53A is formed of a plane member. A long side of the first slide table 53A is placed in the X-axis direction. The first slide table 53A is held horizontally being fixed with the first moving member 51A at each corner of a bottom surface in a minus side of X-axis. Further, the first slide table 53A is movably provided in the X-axis direction.

The pair of second linear guides 52B are provided near edges at the minus side and another side of the Y-axis on the upper surface of the first slide table 53A respectively. The second linear guide 52B are fixed placing a long side of the second linear guide 52B in the X-axis direction. The first moving member 51B is provided slidably to engage with the second linear guides 52B in the X-axis direction.

The second slide table 53B is formed of a plane member. A long side of the second slide table 53B is placed in the X-axis direction. The second slide table 53B is held horizontally by being fixed with the second moving member 51B at each corner on a bottom surface of a minus side of X-axis. Further, the second slide table 53B is movably arranged in the X-axis direction. On the second slide table 53B, three work chucks 54A, 54B and 54C are provided to locate along an outer circumference of the work product W for positioning the work product W.

The arm-drive unit 60 includes a shaft 62, a pair of moving members 61A and 61B and a motor 63. The shaft 62 is a rod-like member and a long side of the shaft 62 is placed in the Y-axis direction in the second vacuum chamber 23. The pair of moving members 61A and 61B are provided on the shaft 62. The motor 63 drives to rotate the shaft 62.

The shaft 62 is rotatably held by a pair of bearings 65 fixed on a side wall of the second vacuum chamber 23 at the minus side of the X-axis. On a circumferential surface of the shaft 62, a male screw 62a is formed in a predetermined region in the plus direction of the Y-axis from a center of the shaft 62. Further, another male screw 62b, which has an opposite screw direction to the male screw 62a with same pitch, is formed in a predetermined region in the minus direction of the Y-axis from a center of the shaft 62.

Two lines L1 and L2 will be now defined. The dashed line Ll is passing the center of the long side of the shaft 62 and is parallel with the X-axis direction. The line Ll is defined as a moving center line. The dashed line L2 is passing through a center axis of the long side of the shaft 62 that is parallel with the γ-axis direction.

The moving member 61A and 61B includes a moving part 61a and a coupling part 61b. The moving part 61a has a rectangular shape and includes a female screw formed at whole inner side of the moving part 61a in the Y-axis direction.

The coupling part 61b is an U-shaped member with respect to a Z-X cross-sectional plane and is fixed to the moving part 61a. Each moving member 61A and 61B is engaged with the male screws 62a and 62b at symmetric positions about the center of the moving center line L1.

The motor 63 is fixed on an outer surface of the side wall of the second vacuum chamber 23 at the minus side of Y-axis. The motor 63 drives to rotate the shaft 62 about the center of the shaft along the Y-axis with a predetermined rotating direction and rpm (revolutions per minute).

As described, the arm-drive unit 60 includes the shaft 62, the pair of the moving members 61A and 61B and the feed screw mechanism. The feed screw mechanism causes the moving members 61A and 61B to move towards opposite direction mutually from each other about the center of the moving center line L1. When the shaft 62 is rotated by the motor 63, the moving members 61A and 61B move along Y-axis direction towards opposite directions from each other (coming closer, separating).

The lazy-tongs arm 70 is formed of a plurality of linked members engaged each other in pantograph form to expand and retract in an X-axis direction.

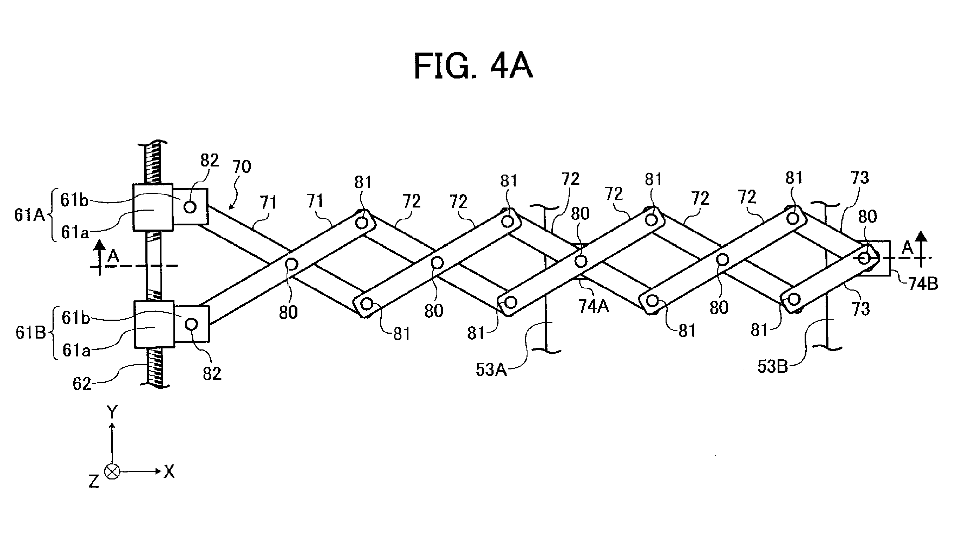

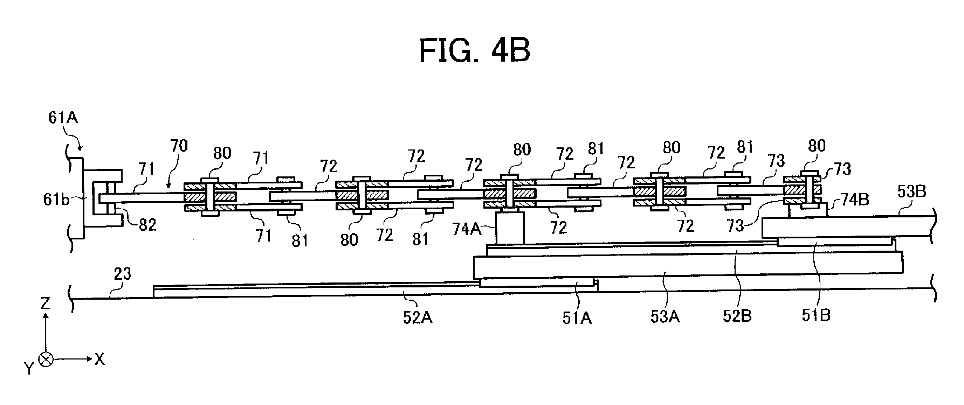

FIG. 4A illustrates a plane view of the lazy-tongs arm 70 when the lazy-tongs arm 70 is expanded. FIG. 4B illustrates a cross-sectional view of the lazy-tongs arm 70 of FIG. 4A. The lazy-tongs arm 70 includes a plurality of linked bar pars 71, center pins 80 and outer pins 81.

The linked bar pars 71 are rotatably coupled across each other by the center pins 80. Similarly, the linked bar pars 72 are rotatably coupled across each other by the center pins 80. The linked bar 72 is rotatably coupled with the linked bar 71 by the outer pin 81 at the end of the linked bar 72.

Further, the linked bar 72 is rotatably coupled with an adjacent linked bar 72 by the outer pins 81 at the end of the linked bar 72. The center pins 80 and the outer pins 81 have a cylindrical conformations. Thus, the lazy-tongs arm 70 is formed to be expandable and retractable.

An end of the linked bar 71 is coupled to the coupling part 61b of the moving member 61A and 61B by a rotating shaft 82. A pair of end-linked bars 73 are provided at an end of the lazy-tongs arm 70 and the plus side of the X-axis. One end of the end-linked bar 73 is rotatably coupled by the outer pins 81 with the end-linked bar 72. Another end of the end-linked bar 73 is rotatably coupled by the center pins 80 with another end-linked bar 73.

The center pins 80 are located on the moving center line Ll. The center pins 80 and outer pins 81 are provided to have an equal distance between neighboring pins respectively. The center pins 80 located in the middle is connected to an upper surface of the first slide table 53A through a connection member 74A at a minus side of X-axis. The center pins 80 located at the most plus side of X-axis is connected to an upper surface of the second slide table 53B through a connection member 74B at the minus side of X-axis.

In the first example embodiment of the present disclosure, the center pins 80 and the outer pins 81 are coupled to linked bars 71, 72 and 73 via needle-bearings by applying fluorinated lubricant agent so that the lazy-tongs arm 70 can move smoothly.

The rotating shaft 82 is supported by the coupling part 61b of the moving members 61A and 61B at upper and bottom ends of the rotating shaft 82. Further, the rotating shaft 82 may be supported via, for example, a ball bearing.

The lazy-tongs arm 70 is being expanded and retracted in the X-axis direction by opening and closing the pair of the linked bars 71 in accordance with the movements of the moving members 61A and 61B of the arm-drive unit 60.

Operation of the vacuum process apparatus 10 will now be described. Initially, the lazy-tongs arm 70 of the conveyance mechanism 100 is in a retracted state as shown in FIG. 3.

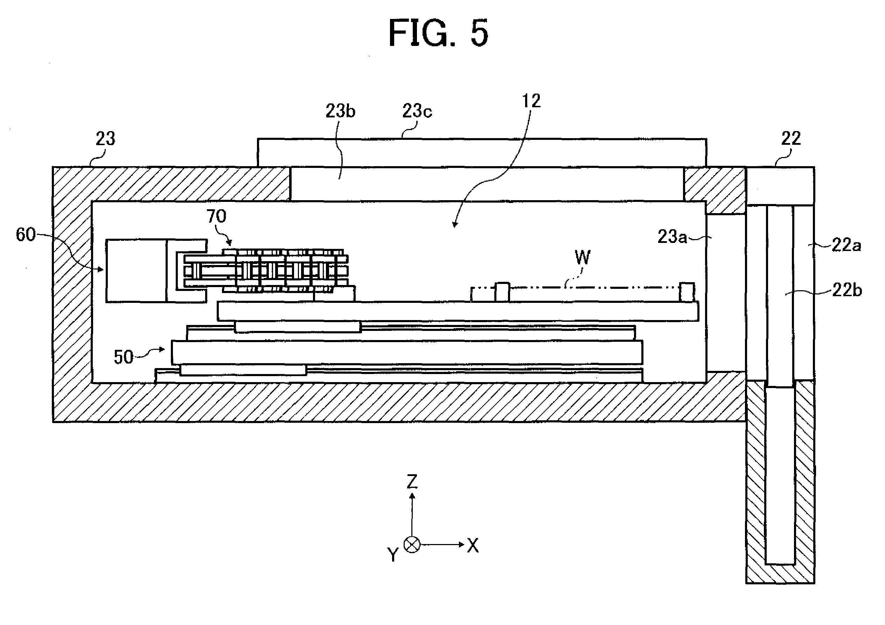

FIG. 5 illustrates the second vacuum chamber 23 when the gate valve 22 is at a closed position. The first vacuum room 11 is kept at a predetermined vacuum condition, for example, a vacuum condition of 10⁻⁴PA.

At this stage, the work product W is not provided on the rotating table 31 and on the second slide table 53B. Positions of the first and second slide tables 53A and 53B are defined as waiting positions. (Refer to FIG. 2)

The work product W is conveyed to a position above the load-lock room 12 by a conveyer (not shown). The opening 23b is opened by sliding the shutter 23c towards the minus direction of the X-axis under a control of a control apparatus (not shown).

The work product W is conveyed to a position above the second slide table 53B of the conveyance mechanism 100 by the conveyer. The opening 23b is closed by sliding the shutter 23c towards the plus direction of the X-axis. As a result, the load-lock room 12 are sealed so as to be evacuated. When the work product W is mounted, a horizontal position of the work product W is then fixed on the second slide table 53B by the work chucks 54A, 54B and 54C.

An inner air of the load-lock room 12 is absorbed by a vacuum pump (not shown) under the control of the controller until, for example, a vacuum condition of 10⁻⁴PA which is equal vacuum condition to the first vacuum room 11. After the vacuum condition of the load-lock room 12 becomes equal to the vacuum condition of the first vacuum room 11, the gate valve 22 is opened.

The controller controls to drive the motor 63 of the arm-drive unit 60 to rotate the shaft 62. The moving members 61A and 61B are driven to be moved towards the minus and plus Y-axis directions respectively. The lazy-tongs arm 70 starts to expand towards the plus direction of X-axis. The first and second slide tables 53A and 53B, which are coupled with the center pins 80 of the lazy-tongs arm 70 through the connection members 74A and 74B respectively, start to move towards the plus direction of X-axis by synchronizing in accordance with the expansion of the lazy-tongs arm 70 as shown in FIG. 4B.

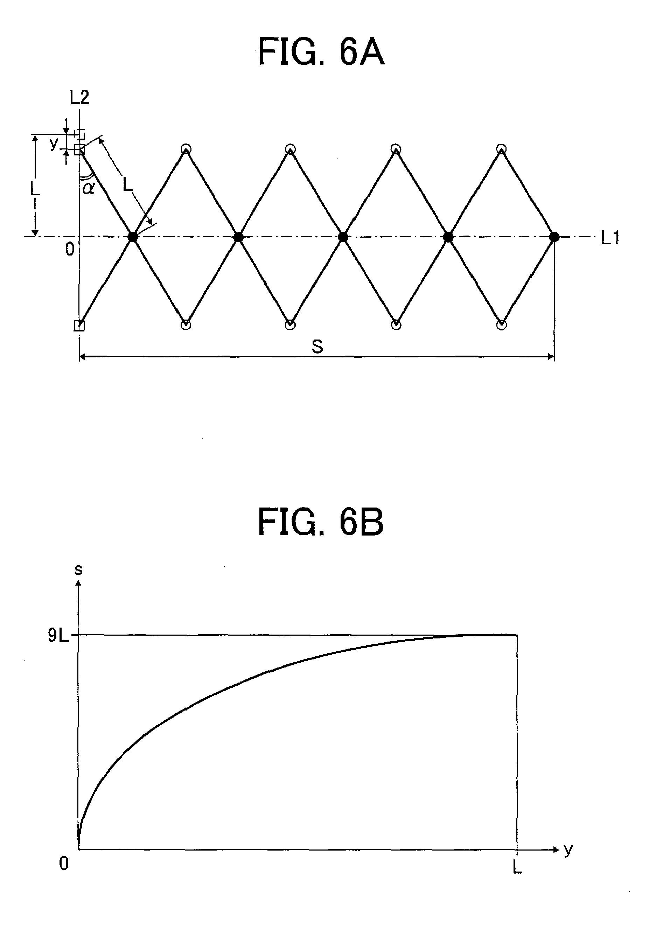

FIGs. 6A and 6B are illustrations to explain a stroke of the lazy-tongs arm 70. In FIG. 6B, positions of the center pins 80 and the outer pins 81 are shown by black and white circles respectively. Further, positions of the moving members 61A and 61B are shown by white squares. Distance between neighboring pins 60 and 81 is defined as L. The stroke of the lazy-tongs arm 70 is defined as S. A displacement of the moving members 61A and 61B from a position, which is away from the moving center Ll by L, is defined as y. To simplify the explanation, the center pin neighboring to the moving members 61A and 61B is located apart from the neighboring moving members 61A and 61B to have a distance of L.

The stroke S of the lazy-tongs arm 70 is expressed by a formula (1),

$$S = k \cdot \sqrt{2 \cdot L \cdot y - y^2}$$
$$= 9 \cdot \sqrt{2 \cdot L \cdot y - y^2} \quad \cdots (1)$$

where y is the displacement of the moving members 61A and 61B (0 < y < 1) and L is the distance between neighboring pins 80 and 81. In this exemplary embodiment, k is 9.

Namely, the stroke S of the lazy-tongs arm 70 is proportional to a square root of quadratic function of the displacement y of the moving members 61A and 61B. A variation of the stroke of the lazy-tongs arm 70 is expressed by a curved line as shown in FIG. 6B. The formula (1) is matched with the distance of the second slide table 53B which is coupled to the center pin 80 at the most plus side of the X-axis.

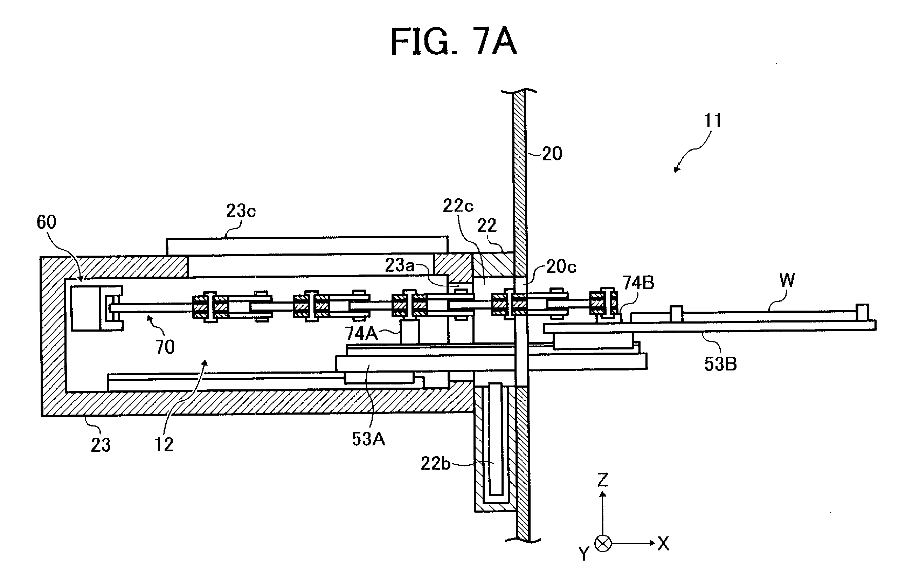

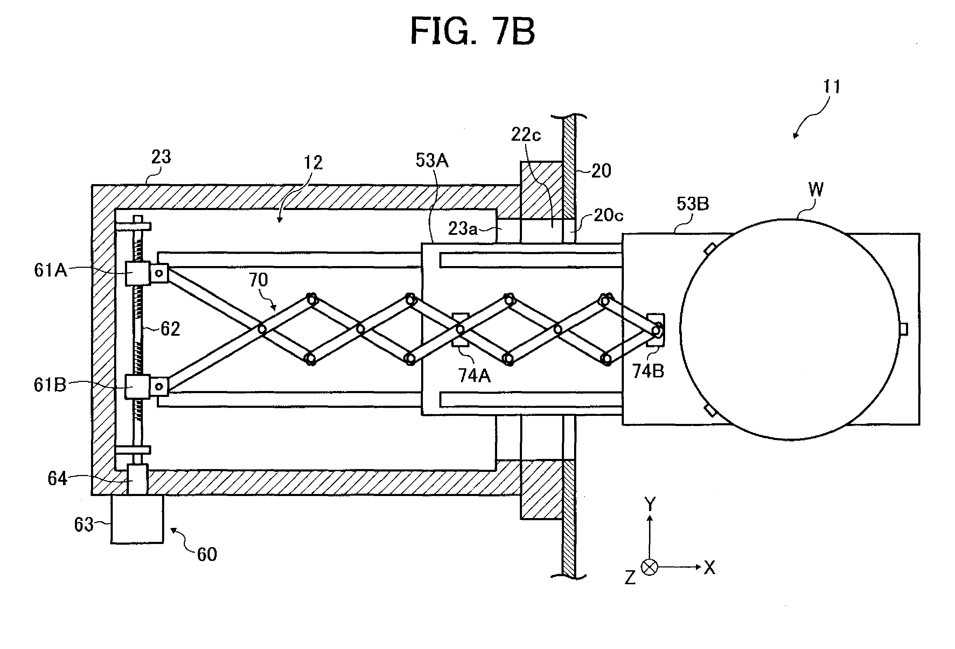

The controller controls the movement of the arm-drive unit 60 based on the curved line of FIG. 6B by monitoring the displacement y of the moving members 61A and 61B. The work product W provided on the second slide table 53B is conveyed to a predetermined position in the first vacuum room 11 by expanding the lazy-tongs arm 70 as shown in FIG. 7A and 7B.

The stroke S' of the first slide table 53A from a waiting position of the second slide table 53B is expressed by a formula (2). The first slide table 53A is coupled to the center pin 80 provided at a middle of the lazy-tongs arm 70.

$$S' = 5 \cdot \sqrt{2 \cdot L \cdot y - y^2} \quad \cdots (2) \quad .$$

Namely, the first and second slide tables 53A and 53B move with a distance $S_{AB}$ between the first and second slide tables 53A and 53B expressed by a following formula (3). Further, the first and second slide tables 53A and 53B move synchronizing with the lazy-tongs arm 70 with each speed S/dt and S'/dt of the first and second slide tables 53A and 53B. Each speed S/dt and S'/dt of the first and second slide tables 53A and 53B are obtained by differentiating each stoke S and S' by time.

$$S_{AB} = S - S' = 4 \cdot \sqrt{2 \cdot L \cdot y - y^2} \quad \cdots (3)$$

When the second slide tables 53B is arrived at a predetermined position in the first vacuum room 11, the controller sends a stop signal to stop the movement of the arm-drive unit 60 so that the expansion of the lazy-tongs arm 70 is stopped. Then, the work product W placed on the first slide tables 53B is grasped by transfer chucks (not shown). The transfer chucks are configured to move vertically. The work product W is picked up and is released from the second slide tables 53B. The work product W is transferred onto the rotating table 31 of the rotating table unit 30.

After the work product W is transferred on the rotating table 31, the controller sends a retracting signal to drive the arm-drive unit 60 to retract the lazy-tongs arm 70. When the first and second slide tables 53A and 53B are arrived at the respective waiting positions, the controller sends a stop signal to stop the movement of the arm-drive unit 60.

Meanwhile, after the gate valve 22 is closed, the work product W is driven to be rotated with a predetermined rotating speed and is to be moved to the X-axis direction with a predetermined speed by the rotating table unit 30. The electron beam emitted from the exposure system 40 is irradiated on the work product W. As a result, a spiral or a concentric fine pattern is drawn on the surface of the work product W.

After the fine pattern is drawn, the work product W is conveyed back to the load-lock room 12 by the conveyance mechanism 100 in reverse order of the steps described above. Further, the work product W is conveyed to outside by a conveyance system (not shown).

As described, according to the conveyance mechanism 100 of the first embodiment of the present disclosure, the conveyance mechanism 100 includes the multiple-layer slider 50 and the lazy-tongs arm 70. The multiple-layer slider 50 includes the first and second slide tables 53A and 53B which move horizontally by sliding. The lazy-tongs arm 70 drives the first and second slide tables 53A and 53B to the X-axis direction.

While the lazy-tongs arm 70 is being expanded and retracted by the driving movement of the arm-drive unit 60, the first and second slide tables 53A and 53B are being driven to move with a predetermined relationship of the distance. Thus, the drive mechanism of the conveyance mechanism 100 can be made simple because it is not necessary to control a plurality of slide tables 53A and 53B separately.

Meanwhile, if pulleys are provided in the first and second slide tables 53A and 53B and the first and second slide tables 53A and 53B are coupled by a belt, the drive mechanism needs a larger number of parts. As a result, the drive mechanism becomes more complicated. Further, in addition to the increase of the parts which are moving, dust particles may be increased.

However, according to the conveyance mechanism 100 of the first embodiment of the present disclosure, it is possible to reduce the dust particles efficiently because of the simple drive mechanism.

At a position where the stroke S of the lazy-tongs arm 70 is taking a larger number, an increment of the stroke S is becoming smaller. The increment of the stroke S is a slope of the curved line of FIG. 6B. This means that it is possible to have a higher resolution for the stroke of the lazy-tongs arm 70 in the X-axis direction when the stroke S of the lazy-tongs arm 70 is taking a larger number. Therefore, the work product W can be controlled precisely to have a predetermined position when the second slide table 53B is conveyed into the first vacuum room 11 by expanding the lazy-tongs arm 70.

The distance $S_{AB}$ between the first and second slide tables 53A and 53B is being kept to follow the formula (3). Therefore, the connection member 74A of the first slide table 53A does not hit the second slide table 53B even when the lazy-tongs arm 70 is retracted. As a result, a moving range of the moving members 51A and 51B does not exceed lengths of the first and second linear guides 52A and 52B.

The vacuum process apparatus 10 according to the first example embodiment of the present disclosure includes the conveyance mechanism 100 as described. It is possible to achieve the simple conveyance system which conveys the work product W between the first vacuum room 11 and the load-lock room 12 and places the work product W accurately at the predetermined position. As a result, a compact and low cost vacuum process apparatus having an excellent performance is realized.

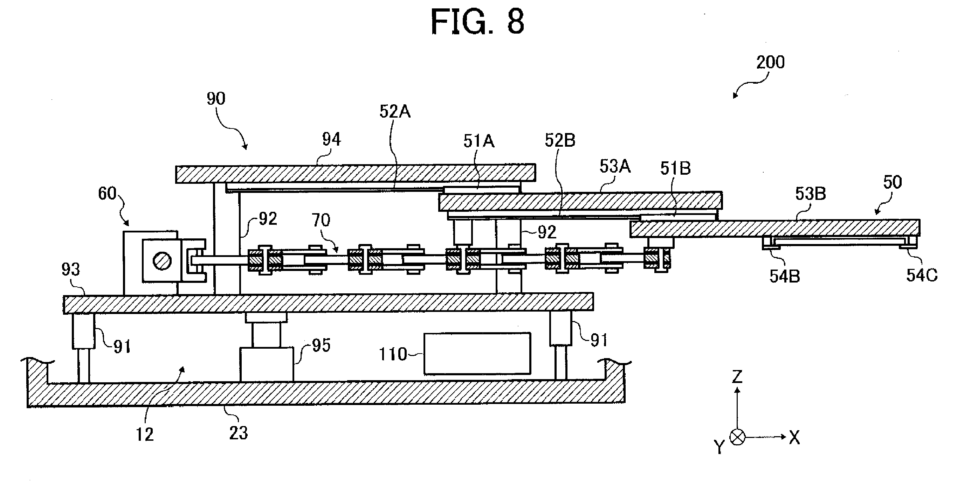

FIGs. 8 to 10 illustrate a vacuum process apparatus according to a second example embodiment of the present disclosure.

FIG. 8 illustrates a cross-sectional view of a conveyance mechanism 200 in a XZ-plain. The conveyance mechanism 200 is provided in the load-lock room 12.

Comparing to the vacuum process apparatus 10 according to the first example embodiment of the disclosure, the multiple-layer slider 50 of the conveyance mechanism 200 and the lazy-tongs arm 70 are provided top side down. The conveyance mechanism 200 is provided in the second vacuum chamber 23 via a vertical motion drive 90. A loader 110 is employed to convey the work product W to the load-lock room 12 from the outside.

The vertical motion drive 90 includes a first unit base 93, four linear-motion guides 91, four support poles 92, a second unit base 94 and a drive shaft 95. The first unit base 93 has a rectangular shape and is held by the four linear-motion guides 91 horizontally. The drive shaft 95 drives to move the first unit base 93 vertically. The second unit base 94 is held horizontally by the four support poles 92 provided on an upper surface of the first unit base 93.

The first linear guides 52A are fixed at an end in a minus side of Y-axis and other end on a rear side of the second unit base 94. A longitudinal side of the first linear guides 52A is provided along the X-axis direction. As a result, the multiple-layer slider 50 of the conveyance mechanism 200 is supported by the vertical motion drive 90.

The arm-drive unit 60 is provided above the first unit base 93. One end of the arm-drive unit 60 is fixed at a minus side of X-axis to an upper surface of the first unit base 93. As described, the conveyance mechanism 200 supported by the vertical motion drive 90 is driven to move vertically by the vertical movement of the drive shaft 95.

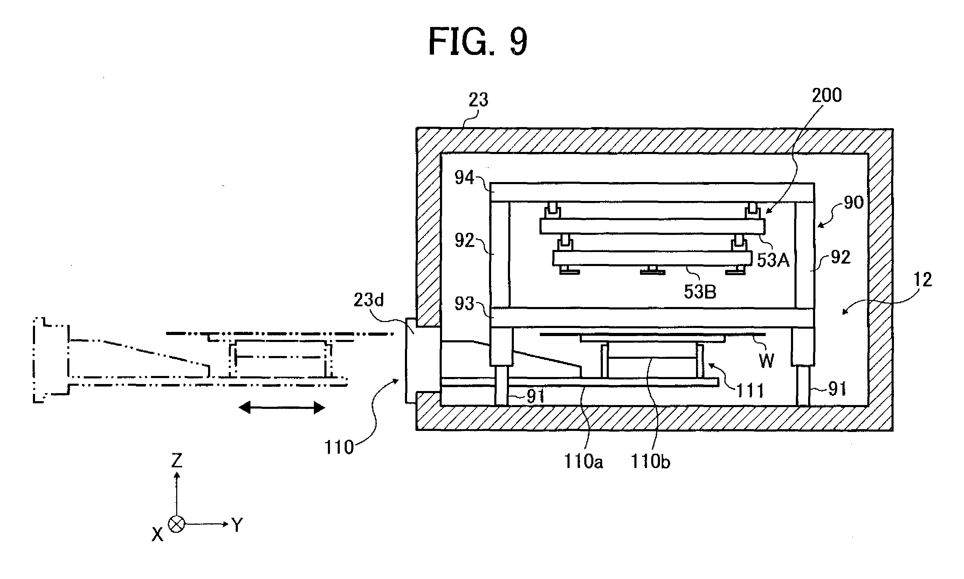

FIG. 9 illustrates an inner view of the second vacuum chamber 23 observing from the plus side of X-axis. The loader 110 includes a loader main body 110a and a table 110b. The table 110b is coupled to the loader main body 110a via parallel links 111. The parallel links 111 include four link-members.

The loader main body 110a moves in a Y-axis direction and includes an engagement section. The engagement section of the loader main body 110a engages with an opening 23d which has a rectangular shape and is provided on a sidewall of the second vacuum chamber at a minus side of Y-axis. The loader main body 110a is driven to reciprocate between a position shown by a virtual image (waiting position) in FIG. 9 and another position shown by a solid line image (conveyed position) by a drive mechanism (not shown).

At the conveyed position, the loader main body 110a stops to move by engagement of the engagement section with an opening 23d. The table 110b is positioned right under the second slide table 53B.

Operation of the conveyance of the work product W by the conveyance mechanism 200 will be described. Initially, the loader 110 is at the waiting position and the work product W is not provided on the conveyance mechanism 200.

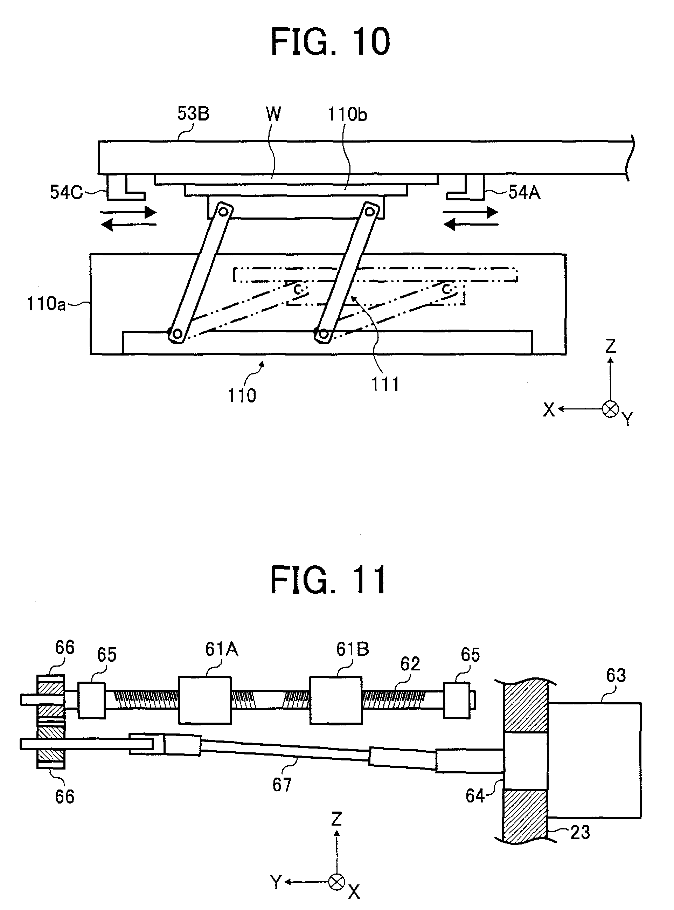

The work product W is provided on the table 100b. The work product W is conveyed to the load-lock room 12 by the movement of the loader 110 towards a plus direction of the X-axis. As shown in FIG. 10, the parallel links 111 of the loader main body 110a are driven to move to the position shown by the solid image by a drive mechanism (not shown). As a result, the work product W is clamped onto an undersurface the second slide table 53B by the table 110b.

The work product W is fixed by the work chucks provided on the second slide table 53B. The work chucks may be a L-shape-three-claw chuck 54A to 54C, or a rotary-three-claw chuck. In this example embodiment, the L-shape-three-claw chuck is employed. The L-shape-three-claw chuck fixes the work product W by moving in a radial direction as shown in FIG. 10. The rotary-three-claw chuck fixes the work product W by rotating a longitudinal part of a L-shape member. The work product W may be fixed by vacuum adsorption or electrostatic adsorption.

The parallel links 111 of the loader 110 are driven to move down to positions shown by the chained line in FIG. 10. The work product W is conveyed to a position above the rotating table 31 in the first vacuum room 11 by the conveyance mechanism 200.

The work product W is moved down to a closer position to the rotating table 31 by downward movement of the conveyance mechanism 200 by the vertical motion drive 90. The work product N is released from the work chucks 54A to 54C and is placed onto the rotating table 31. Then, a fine pattern is drawn on the work product W. After drawing the fine pattern, the work product W is conveyed back to the outside in reverse order of the steps described above.

As described, according to the vacuum process apparatus according to the second embodiment of the present disclosure, the conveyance mechanism 200 is moved downward by the vertical motion drive 90. The work product W is placed onto the rotating table 31 of the rotating table unit 30 without using the transfer chucks which are movable vertically.

Therefore, the transfer mechanism, which transfers the work product W from the conveyance mechanism 200 to the rotating table 31, is not necessary in the first vacuum room 11. As a result, it is possible to form the vacuum process apparatus more compact. Further, the vacuum room can be kept at a low vacuum level because of achieving a low dust level.

In the vacuum process apparatus according to the second embodiment of the present disclosure, the arm-drive unit 60 is provided on the first unit base 93 as shown in FIG. 8. However, when the motor 93 is arranged outside of the load-lock room, the driving force of the motor 63 may be transferred to the shaft 62 via a pair of gears 66 and an universal joint 67 as shown in FIG. 11. Employing this configuration, the motor 63 can drive the shaft 62 so that the work product W can be efficiently conveyed in the horizontal and vertical directions even when the shaft 62 is jogging.

In each conveyance mechanism 100 and 200 according to the first and second embodiments of the present disclosure, the lazy-tongs arm 70 is formed of a plurality of linked bars (cross links) 72 across each other and are rotatably connected by the center pins 80. A number of the cross links may not be three and may be equal to and more than four, or may be equal to and less than two.

When the number of the cross links of the lazy-tongs arm 70 is plural, an allowance may become large in a x-axis direction when the lazy-tongs arm 70 is retracted. If the allowance is larger than a predetermined amount, a waiting position of 53A and 53B may be shifted. As a result, a positioning accuracy is decreased.

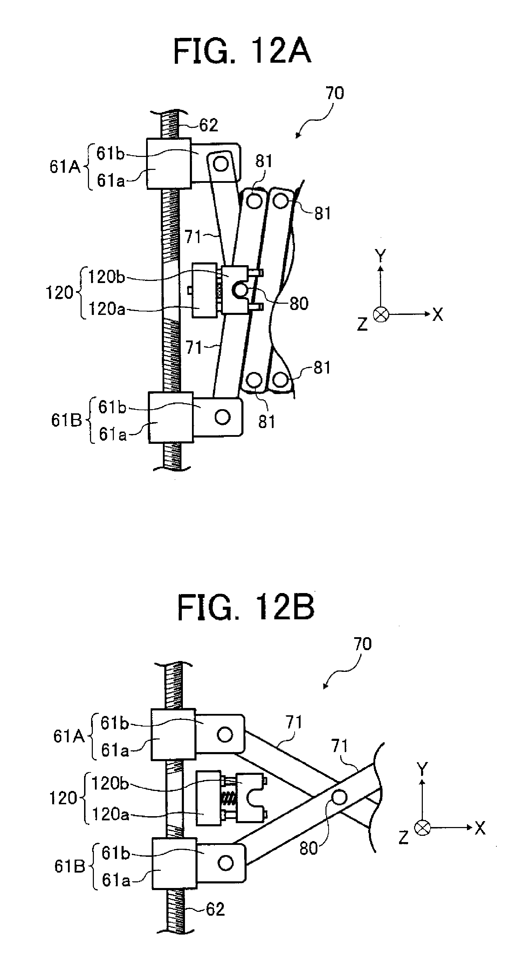

For one example, the carrying mechanisms 100 and 200 include a pressuring unit 120 provided in a middle of the shaft 62 to give a force to the lazy-tongs arm 70. The pressuring unit 120 includes fixtures 120a and 120b. The lazy-tongs arm 70 is supported by the fixtures 120a and 120b and is possible to slide in the x-axis direction as shown in FIGs. 12A and 12B. The fixtures 120a and 120b are supported by a support member (not shown). Further, the fixture 120b is pushed by an elastic member, such as spring, in the plus direction of the X-axis.

When the lazy-tongs arm 70 is retracted, the center pin 80 which connect the link bars 71 is pushed by the fixture 120b of the pressuring unit 120 towards the plus direction of the X-axis. With this configuration, the slide table 53A and 53B are positioned at predetermined waiting positions respectively when the lazy-tongs arm 70 is retracted. As a result, the positioning accuracy can be improved.

In the conveyance mechanism 100 and 200 according to the embodiments of the present disclosure, when sensor and drive mechanism are provided on the first and second slide tables 53A and 53B, a cable 83 can be provided through a hollow part of the outer pin 81 as a guide. Similarly, it is possible to provide hose pipes which supply, for example, driving air and cooling water.

In the conveyance mechanism 100 and 200 according to the embodiments of the present disclosure, the first slide table 53A is connected to the center pin 80 located in the middle of the lazy-tongs arm 70. However, the first slide table 53A may be connected to other center pin 80 to match the stroke of the lazy-tongs arm 70.

In the conveyance mechanism 100 and 200 according to the embodiments of the present disclosure, the multiple slider 50 includes two slide tables 53A and 53B. However, the multiple-layer slider may include three or more sliders.

In the conveyance mechanism 100 and 200 according to the embodiments of the present disclosure, the arm-drive unit 60 includes the shaft 62 and the moving members 61A and 61B. However, the arm-drive unit 60 may employ a rack-and-opinion.

In the conveyance mechanism 100 and 200 according to the embodiments of the present disclosure, the work product W is conveyed between two rooms under a predetermined vacuum condition. However, the work product W may be conveyed between two rooms under a condition of an inactive gas.

Numerous additional modifications and variations are possible in light of the above teachings. It is therefore to be understood that within the scope of the appended claims, the disclosure of this patent specification may be practiced otherwise than as specifically described herein.

**Claims**

**1.** A conveyance apparatus, comprising:

an extendable and retractable mechanism including a plurality of linked member pairs rotatably coupled across each other horizontally in a predetermined direction in pantograph form; and
a multiple-layer slider including:

a carrier slider to hold a work product and fixed at one end of the extendable mechanism; and
at least one movable slider to move in a predetermined direction keeping a predetermined relative position to the carrier slider; and

a drive mechanism configured to cause the linked member pairs to expand by changing a relative angle of the crossing linked member pairs.

**2.** The conveyance apparatus of claim 1,
wherein the sliders of the multiple-layer slider are provided in a gravitational force direction, and wherein the carrier slider is provided at an upper side in the gravitational force direction.

3. The conveyance apparatus of claim 1, further comprising:

a biasing mechanism configured to apply a force to the extendable mechanism in a tension direction when the extendable mechanism is at a retracted condition.

4. The conveyance apparatus of claim 1, wherein the carrier slider is connected to a junction of the linked member pairs.

5. The conveyance apparatus of claim 1, wherein the carrier slider includes a holding mechanism to hold the work product.

6. The conveyance apparatus of claim 1, wherein the pair of linked members are connected by a hollow shaft, wherein the holding mechanism is driven by an electric signal transmitted via a wire cable passed through the hollow shaft.

7. A vacuum process apparatus that employs the conveyance apparatus of claim 1, further including:

a vacuum process room provided to draw a fine pattern onto the work product therein; and a load-lock room connected to the vacuum process room through a gate valve,

wherein the conveyance apparatus is provided in the load-lock room and carries the work product, which is conveyed from outside of the load-lock room, to the vacuum process room.

# FIG. 1

EP 1 835 532 A1

# FIG. 2

EP 1 835 532 A1

FIG. 3

FIG. 4A

## FIG. 4B

EP 1 835 532 A1

# FIG. 5

EP 1 835 532 A1

# FIG. 6A

# FIG. 6B

# FIG. 7A

EP 1 835 532 A1

# FIG. 7B

EP 1 835 532 A1

# FIG. 8

EP 1 835 532 A1

# FIG. 9

EP 1 835 532 A1

# FIG. 10

53B  W  110b

54C  54A

110a

110  111

Z

X  ⊗Y

# FIG. 11

66  65  61A  61B  62  65  63

66  67  64  23

Z

Y  ⊗X

# FIG. 12A

# FIG. 12B

FIG. 13

EP 1 835 532 A1

**EP 1 835 532 A1**

**European Patent Office**

**EUROPEAN SEARCH REPORT**

Application Number

EP 07 10 3586

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/036877 A1 (OGAWA ET AL.) 17 February 2005 (2005-02-17) * paragraphs [0111], [0116]; figures 17-25 * | 1,2,4,7 | INV. H01L21/67 |
| Y | | 3,5,6 | |
| Y | US 5 588 789 A (MUKA ET AL.) 31 December 1996 (1996-12-31) * figure 5 * | 3 | |
| A | | 1 | |
| Y | WO 03/008157 A (BROOKS AUTOMATION, INC.) 30 January 2003 (2003-01-30) * abstract * | 5 | |
| A | | 1 | |
| Y | US 2003/085681 A1 (SAKAMOTO ET AL.) 8 May 2003 (2003-05-08) * abstract; figure 1 * | 6 | |
| A | | 1 | |
| | | | TECHNICAL FIELDS SEARCHED (IPC) |
| A | GB 2 362 373 A (SAMSUNG ELECTRONICS CO, LTD.) 21 November 2001 (2001-11-21) * abstract; figure 5B * | 1 | H01L B25J |
| A | JP 01 217939 A (TEL SAGAMI LTD) 31 August 1989 (1989-08-31) * abstract * | 1 | |

The present search report has been drawn up for all claims

| Place of search | Date of completion of the search | Examiner |
|---|---|---|
| The Hague | 3 July 2007 | Oberle, Thierry |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

24

**ANNEX TO THE EUROPEAN SEARCH REPORT
ON EUROPEAN PATENT APPLICATION NO.**

EP 07 10 3586

This annex lists the patent family members relating to the patent documents cited in the above-mentioned European search report.
The members are as contained in the European Patent Office EDP file on
The European Patent Office is in no way liable for these particulars which are merely given for the purpose of information.

03-07-2007

| Patent document cited in search report | | Publication date | Patent family member(s) | | Publication date |
|---|---|---|---|---|---|
| US 2005036877 | A1 | 17-02-2005 | JP | 2005125479 A | 19-05-2005 |
| US 5588789 | A | 31-12-1996 | AU | 6337796 A | 05-02-1997 |
| | | | EP | 0836577 A1 | 22-04-1998 |
| | | | JP | 3272729 B2 | 08-04-2002 |
| | | | JP | 9508758 T | 02-09-1997 |
| | | | WO | 9702195 A1 | 23-01-1997 |
| WO 03008157 | A | 30-01-2003 | AU | 2002332417 A1 | 03-03-2003 |
| | | | JP | 2004535681 T | 25-11-2004 |
| | | | US | 2003035711 A1 | 20-02-2003 |
| US 2003085681 | A1 | 08-05-2003 | CN | 1411960 A | 23-04-2003 |
| | | | JP | 2003117877 A | 23-04-2003 |
| | | | KR | 20030032853 A | 26-04-2003 |
| | | | TW | 592912 B | 21-06-2004 |
| GB 2362373 | A | 21-11-2001 | JP | 2001354302 A | 25-12-2001 |
| | | | TW | 514618 B | 21-12-2002 |
| JP 1217939 | A | 31-08-1989 | JP | 2512782 B2 | 03-07-1996 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006067710 A